Europäisches Patentamt

**European Patent Office**

**Office européen des brevets**

(11) Veröffentlichungsnummer: **0 088 972**

**A1**

(12) **EUROPÄISCHE PATENTANMELDUNG**

(21) Anmeldenummer: **83102190.2**

(22) Anmeldetag: **05.03.83**

(51) Int. Cl.³: **G 01 R 15/07**
**H 01 L 31/12, G 01 D 5/26**

(30) Priorität: **15.03.82 SE 8201601**

(43) Veröffentlichungstag der Anmeldung:
**21.09.83 Patentblatt 83/38**

(84) Benannte Vertragsstaaten:
**CH DE FR GB LI**

(71) Anmelder: **ASEA AB**

**S-721 83 Västeras(SE)**

(72) Erfinder: **Brogardh, Torgny**
**Platverksgatan 140**
**S-724 74 Västeras(SE)**

(72) Erfinder: **Hök, Bertil, Dr. phil.**
**Sportfiskargatan 53**
**S-723 48 Västeras(SE)**

(72) Erfinder: **Ovrén, Christer, Dr. techn.**
**Vilddjursvägen 9**
**S-722 43 Västeras(SE)**

(74) Vertreter: **Boecker, Joachim, Dr.-Ing.**
**Rathenauplatz 2-8**
**D-6000 Frankfurt a.M. 1(DE)**

(54) **Faseroptische Messanordnung.**

(57) Faseroptische Messanordnung zur Messung elektrischer
und magnetischer Größen. Die Meßanordnung besteht aus
einem Geber (G) und einer Elektronikenheit (E), die über
mindestens eine optische Faser (11) miteinander verbunden
sind. Der Geber enthält mindestens ein optisches Absorptionsfilter oder Interferenzfilter, und die Elektronikeinheit (E)
enthält mindestens zwei Lichtquellen (1, 2) mit verschiedenen Emmissionsspektren. Die genannten optischen Filter
liegen im Strahlengang zwischen der Endfläche der optischen Faser (11) und einer lumineszenzfähigen Materialschicht (16) im Geber.

EP 0 088 972 A1

Patentanwalt und Rechtsanwalt
Dr.-Ing. Dipl.-Ing. Joachim B o e c k e r

6 Frankfurt/Main 1 , 4.2.1983
Rathenauplatz 2-8    0088972 PE
Telefon: (06 11) *28 23 55
Telex: 4 189 066 itax d

A S E A    Aktiebolag
Västeras/Schweden


Faseroptische Meßanordnung


Die Erfindung betrifft eine faseroptische Meßanordnung gemäß dem Oberbegriff des Anspruches 1.

Für den industriellen Meßsektor besteht ein großer Bedarf, auf billige und zuverlässige Weise Strom, Spannung und magnetische Felder mit faseroptischen Gebern messen zu können. Für Anwendungsgebiete, auf denen ein höherer Preis hingenommen werden kann, sind bereits Meßanordnungen entwickelt worden (siehe beispielsweise die europäische Patentanmeldung 79 10 3445.7), die mit einer sogenannten optisch gespeisten Elektronik arbeiten. Dabei wird Licht über eine oder mehrere optische Fasern zu einer oder mehreren Fotodioden geleitet, welche eine elektrische Größe erzeugen, die von elektronischen Gliedern, wie Verstärkern, Vergleichern und analogen Schaltern, verarbeitet wird.

Der Erfindung liegt die Aufgabe zugrunde, eine Meßanordnung der eingangs genannten Art zu entwickeln, bei der eine bedeutend verminderte Komplexität auf der Sensorseite die Verwendung von billigen und zuverlässigen Gebern für elektrische und magnetische Größen ermöglicht.

Zur Lösung dieser Aufgabe wird eine Meßanordnung nach dem Oberbegriff des Anspruches 1 vorgeschlagen, die erfindungsgemäß die im kennzeichnenden Teil des Anspruches 1 genannten

/2

Merkmale hat.

Vorteilhafte Weiterbildungen der Erfindung sind in den Unteransprüchen genannt.

Der Geber der Meßanordnung gemäß der Erfindung basiert auf
einer elektrisch gesteuerten Fotolumineszenz und hat trotz
seiner Einfachheit dadurch eine hohe Leistung, daß der Sensor
mit einem Meß- und einem Bezugselement integriert wird. Durch
die Erfindung wird eine völlig neue Art von Sensorstruktur
in beispielsweise GaAlAs geschaffen, die eine Gesamtintegration in diesem Material von sowohl Optokomponenten wie Sensorelektronik ermöglicht und die durch selektive optische
Abtastung von unterschiedlichen GaAlAs-Komponenten auch eine
optisch analoge Meßwertübertragung und Wellenlängendemultiplexierung ermöglicht.

Anhand der Figuren soll die Erfindung näher erläutert werden. Es zeigen:

Fig. 1 ein Ausführungsbeispiel für den Aufbau einer
kompletten Meßanordnung gemäß der Erfindung,

Fig. 2a und 2b ein Ausführungsbeispiel eines Sensors
in Form epitaxial gezüchten Halbleitermaterials
in zwei Ansichten,

Fig. 3a und 3b spektrale Zusammenhänge bei Meßanordnungen
gemäß der Erfindung,

Fig. 4 ein Ausführungsbeispiel für den elektrischen Anschluß von Sensorelementen an Ohmsche Geber,

Fig. 5 ein Ausführungsbeispiel für den Anschluß von
Sensorelementen an Transistorkreise,

Fig. 6 ein Ausführungsbeispiel für den Anschluß von
Sensorelementen an eine äußere Spannungsquelle,

Fig. 7 ein Ausführungsbeispiel eines Sensors mit integrierter Transistorfunktion,

Fig. 8 ein äquivalentes Schema (Schaltbild) für den
Sensor gemäß Fig. 7

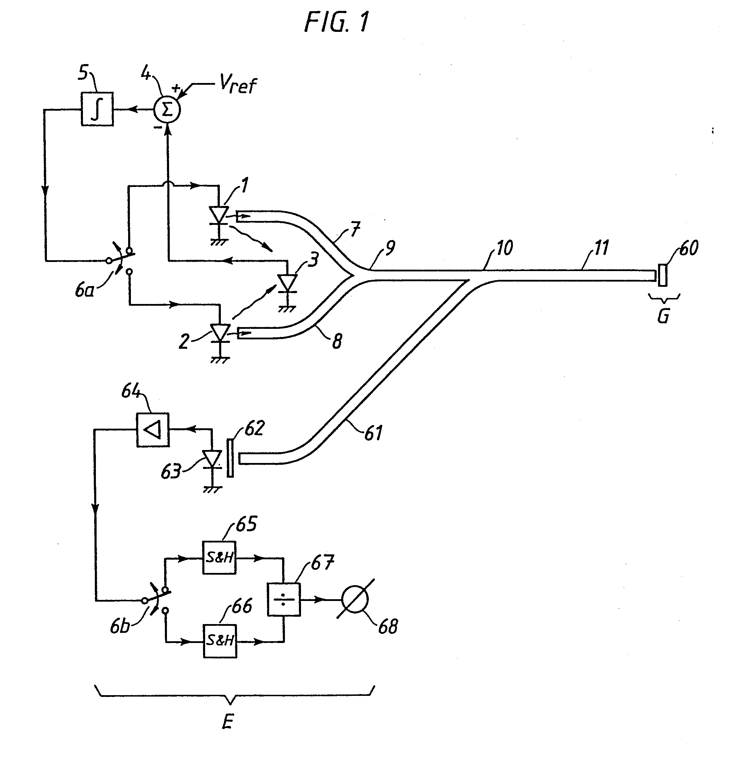

In Figur 1 wird mit Hilfe des Schalters 6a abwechselnd den beiden Leucht- oder Laserdioden 1 und 2 ein Injektionsstrom zugeführt. Das von diesen Dioden abgegebene Licht wird über die optischen Fasern 7 und 8, die optischen Verzweigungen 9 und 10 und die optische Faser 11 zu dem Geber 60 geleitet. Um das Verhältnis zwischen den Lichtintensitäten der beiden Lichtquellen 1 und 2 zu erhalten, wird ein Teil des von ihnen ausgesandten Lichtes auf eine Fotodiode 3 geleitet, deren Fotostrom in einem Differenzbilder 4 mit einem Bezugssignal $V_{ref}$ verglichen wird, wobei der Differenzwert über einen Integrator 5 zur Regelung der Injektionsströme für die Lichtquellen 1 und 2 dient. Das Licht von den Lichtquellen 1 und 2 verursacht eine Fotolumineszenz an verschiedenen Teilen derselben Lumineszenzschicht im Geber 60. Ein Teil des auf diese Weise erzeugten Lumineszenzlichtes wird über die Faser 11, die Verzweigung 10, die Faser 61 und das optische Filter 62 auf den Fotodetektor 63 geleitet. Das vom Fotodetektor 63 abgegebene Signal wird im Verstärker 64 verstärkt und vom Schalter 6b im Takte mit dem Schalten des Schalters 6a für die Lichtquellen 1 und 2 den S & H-Gliedern 65 und 66 (Sample und Hold-Glied)zugeführt. Ein S&H-Glied ist ein solches, welches den einmal an seinem Eingang vorhanden gewesenen Wert speichert und als Ausgangsgröße abgibt. Sobald eine neue Eingangsgröße erscheint, wird diese statt der bisherigen gespeichert und am Ausgang abgegeben. Die Ausgangsgrößen der S&H-Glieder werden einem Quotientenbilder 67 zugeführt, dessen Ausgangsgröße der Quotient der beiden Eingangsgrößen ist und das Meßsignal darstellt, das von dem Anzeigegerät 68 angezeigt wird.

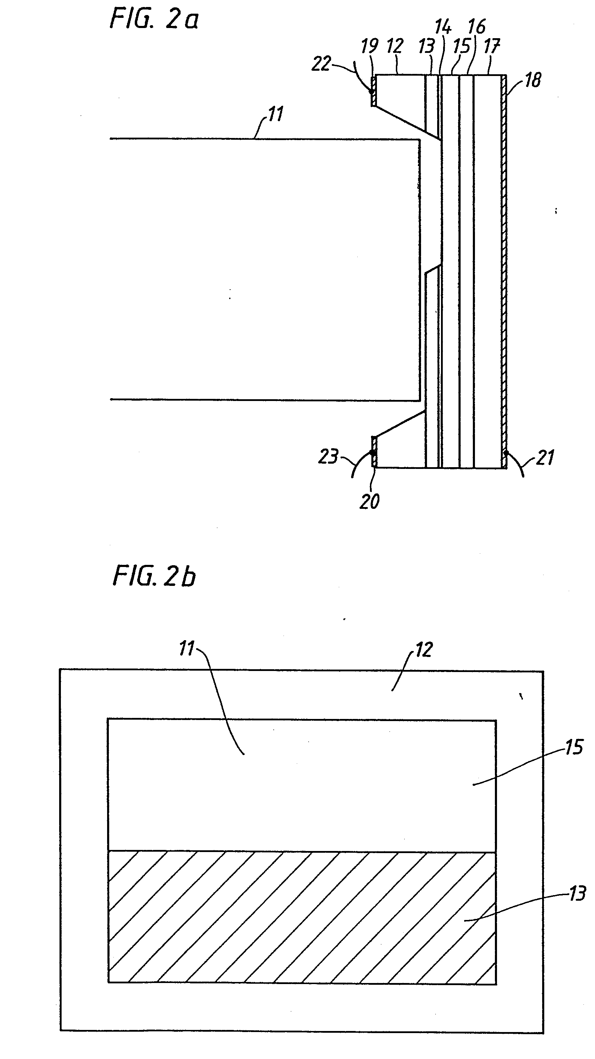

Figur 2 zeigt ein Ausführungsbeispiel für den Aufbau des Gebers 60, wobei Figur 2a den Geber von der Seite und Figur 2b den Geber von vorn auf der optischen Faser 11 zeigt. Der Geber wird vorzugsweise im Epitaxialverfahren hergestellt , und wenn man dabei in einem $Ga_xAl_{1-x}As$-System

/4

arbeitet, können die einzelnen Schichten folgenden Aufbau haben:

| | |
|---|---|
| Schicht 18, 19, 20: | Metallschichten zur Bildung ohmscher Kontakte |
| Schicht 12: | n-dotiertes GaAs-Substrat |
| Schicht 13: | n-dotiertes $Ga_{x_1}Al_{1-x_1}As$ |
| Schicht 14: | n-dotiertes $Ga_{x_2}Al_{1-x_2}As$, $x_2 > x_1$ |
| Schicht 15: | n-dotiertes $Ga_{x_3}Al_{1-x_3}As$, $x_3 > x_1$ |
| Schicht 16: | p-dotiertes GaAs |
| Schicht 17: | p-dotiertes $Ga_{x_4}Al_{1-x_4}As$, $x_4 > 0$. |

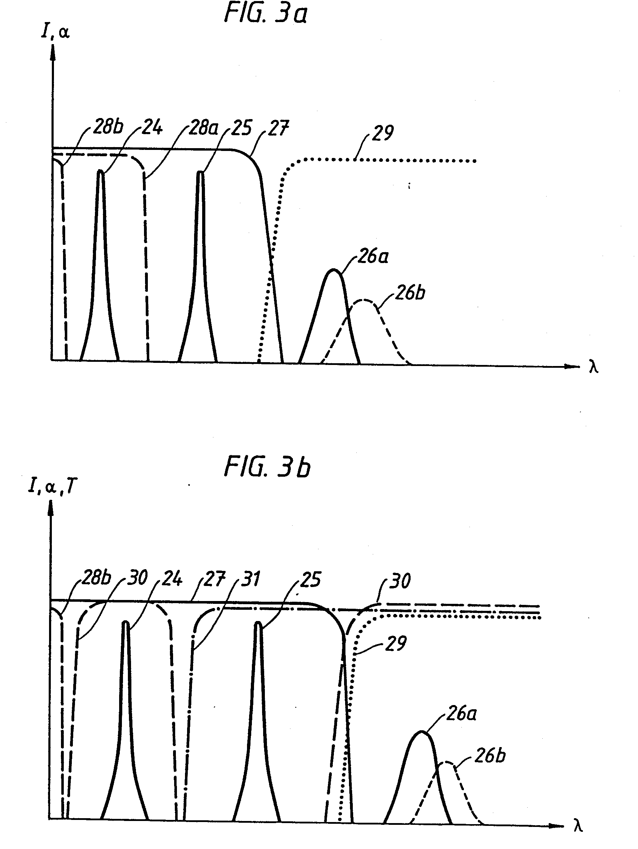

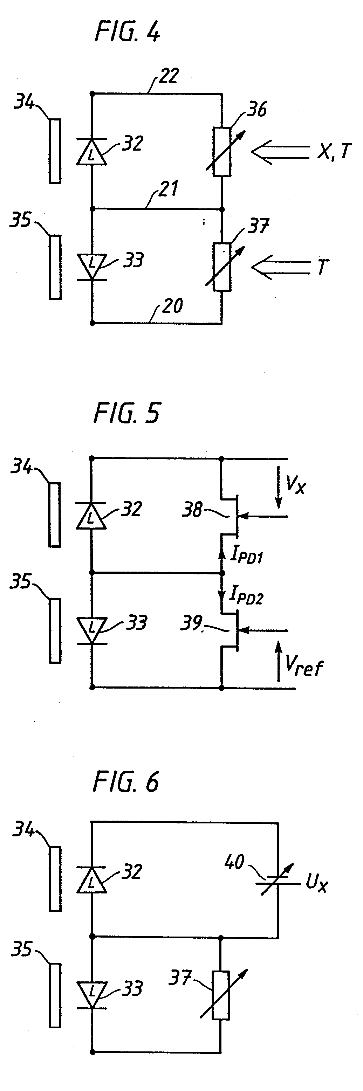

Figur 3a zeigt die spektralen Zusammenhänge in einer Meßanordnung nach Figur 1 mit einer Geberausführung gemäß Figur 2, und Figur 3b zeigt die spektralen Zusammenhänge, wenn die Schicht 13 durch zwei Interferenzfilter 34 und 35 ersetzt wird (siehe Figur 4). Die einzelnen Kurven in den Figuren 3a und 3b sind:

| | |
|---|---|
| Kurve 24: | das Emissionsspektrum der Leuchtdiode 1 |
| Kurve 25: | das Emissionsspektrum der Leuchtdiode 2 |
| Kurve 26a: | das Fotolumineszenzspektrum der Schicht 16 bei der Temperatur $T_1$ |
| Kurve 26b: | das Fotolumineszenzspektrum der Schicht 16 bei der Temperatur $T_1 > T_2$ |
| Kurve 27: | das Absorptionsspektrum der Schicht 16 |
| Kurve 28a: | das Absorptionsspektrum der Schicht 13 |
| Kurve 28b: | das Absorptionsspektrum der Schicht 15 |
| Kurve 29: | das Transmissionsspektrum des Filters 62 |
| Kurve 30: | das Transmissionsspektrum des Interferenzfilters 34 (beachte, daß das Filter 34 sowohl 24 wie 26 hindurchläßt) |
| Kurve 31: | das Transmissionsspektrum des Interferenzfilters 35. |

- 5 -

In den Figuren 3a und 3b bedeutet $\lambda$ die Wellenlänge, I die Intensität, $\alpha$ die Absorption und T die Transmission.

Figur 4 zeigt ein äquivalentes Schema für einen Geber mit zwei Interferenzfiltern 34 und 35 statt eines Absorptionsfilters 13 in Figur 2a. Die äquivalenten Dioden mit den Anschlüssen 20, 21 und 22, die auch in Figur 2a markiert sind, sind an zwei Widerstände 36 und 37 angeschlossen, wobei der Wert des Widerstandes 36 von einer Meßgröße X, beispielsweise von einem Magnetfeld bei einem magnetoohmschen Element, beeinflußt wird und der Widerstand 36 als Bezugselement, vorzugsweise für eine Temperaturkompensation, dient. Der Pfeil T bezeichnet ein Temperaturbezugssignal und X bezeichnet, wie bereits erwähnt, das Meßsignal (Figur 4).

Die Arbeitsweise der Meßanordnung soll anhand der Figuren 1, 2, 3b und 4 erläutert werden:

Wenn die Leuchtdiode 1 Strom empfängt, wird die obere Diode 32 in Figur 4 beleuchtet, während die Diode 33 im Dunkeln liegt. Dies bewirkt einen Fotostrom durch den Widerstand 36 und damit einen Spannungsfall an diesem Widerstand, der von der Größe dieses Widerstandes und damit von dem Meßwert X abhängig ist. Die Größe dieser Spannung bestimmt den Arbeitspunkt der I-V-Charakteristik der Diode 32 und die Größe des Fermi-Niveausprunges an dem pn-Übergang zwischen den Schichten 15 und 16. Zur gleichen Zeit, in der ein Fotostrom dadurch entsteht, daß optisch erzeugte Minoritätsladungsträger in der Schicht 16 aufgrund der elektrischen Feldstärke an dem pn-Übergang zwischen diesen Schichten zur Schicht 15 abgesaugt werden, entsteht in der Schicht 16 dadurch Fotolumineszenz, daß ein Teil der optisch erzeugten Minoritätsladungsträger mit Löchern in dieser Schicht während des Aussendens von Licht rekombinieren. Diese Lumineszenz ist von der Konzentration der Minoritätsladungsträger in der Schicht 16 abhängig und wird somit vom Fotostrom moduliert. Um eine gute Effektivität der Lumineszenz

/6

- 6 -

zu erhalten, werden Ladungsträger in die Schicht 16 eingeschlossen, indem die Schichten 15 und 17 einen höheren
Al-Gehalt und damit einen größeren Bandabstand als die
Schicht 16 bekommen. Wenn der Widerstand 36 einen großen
Wert hat, erhält man einen kleinen Fotostrom und damit eine
hohe Lumineszenz,während man bei kleinen Widerstandswerten
einen größeren Fotostrom erhält. Somit gelangt, wenn die
Leuchtdiode 1 Strom empfängt, Fotolumineszenzlicht zu dem
Detektor 63, das von der Meßgröße X abhängig ist.

Wenn die Leuchtdiode 2 Strom empfängt, wird nur die untere
Fotodiode 33 in Figur 4 beleuchtet (siehe die spektralen
Zusammenhänge in Figur 3b), und genauso, wie vorstehend
beschrieben , erhält man ein Lumineszenzlicht am Detektor
63, das von dem Widerstand des Bezugswiderstandes 37 abhängig ist. Durch die S&H-Technik können die Fotolumineszenzsignale für die beiden Anregungsintervalle isoliert und
einem Quotientenbilder und/oder einem anderen Berechnungsglied zugeführt werden, welches ein Meßsignal an das Anzeigegerät 68 liefert, das von der Temperatur des Gebers, von
alterungsbedingten Änderungen am Geber und von der Lichtdämpfung des optischen Fasersystems unabhängig ist. Das
Filter 62 hat die Aufgabe, Licht zu blockieren, das von
den Leuchtdioden 1, 2 infolge von Reflektionen im optischen
Fasersystem am Ende der Faser 61 erscheint. Damit ist das
Meßsignal auch von Reflektionen in den faseroptischen Verbindungen und Anschlüssen unabhängig.

Wenn mit der Meßanordnung elektrische Spannungen gemessen
werden sollen, kann die zu messende Spannung entweder direkt
an eine der Fotodioden gelegt werden, wie dies Figur 6 zeigt,
oder es können zur Modulation des Fotolumineszenzlichtes
Transistoren verwendet werden, wie dies die Figuren 5 und
8 zeigen. Die Feldeffekttransistoren 38, 39 in Figur 5
werden einfach als spannungsgesteuerte Widerstände benutzt,
so daß sie sich in gleicher

/7

Weise verhalten wie die Widerstände 36 und 37 in Figur 4. Die Spannungsquelle 40 in Figur 6 moduliert den Fermi-Niveausprung am pn-Übergang zwischen den Schichten 15 und 16 und damit das elektrische Feld, welches Minoritätsladungsträger aus der Schicht 16 absaugt. Bei kleinen Werten von $U_x$ wird der Fotostrom größer und die Fotolumineszenz kleiner, während mit steigenden Werten von $U_x$ der Fotostrom kleiner und die Fotolumineszenz größer wird, und bei allzu hohen Werten von $U_x$ werden Minoritätsladungsträger in die Schicht 16 injiziert.

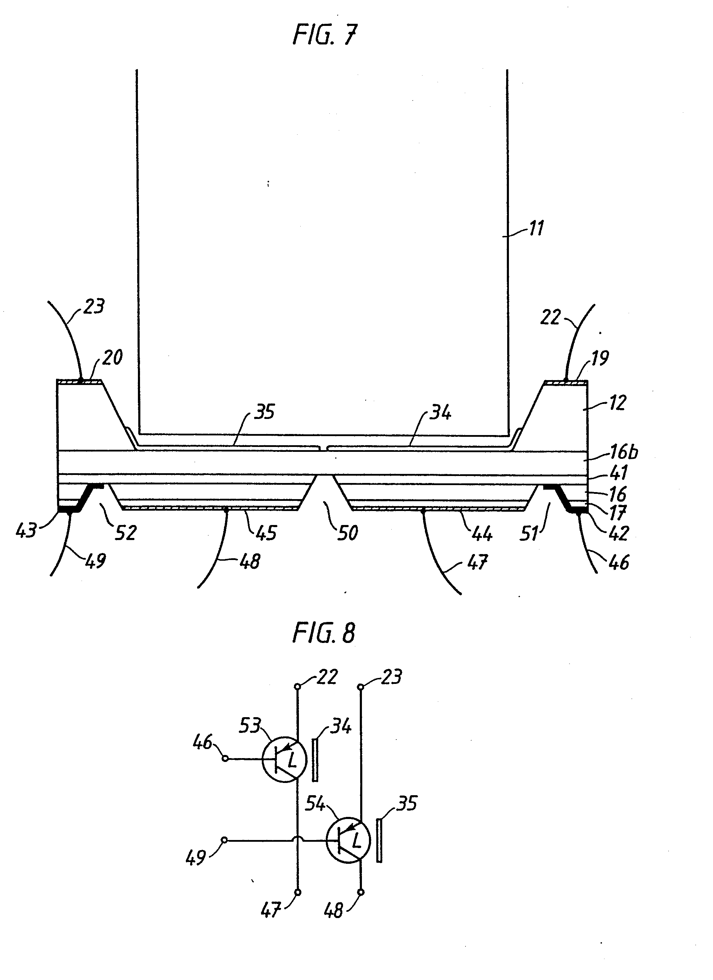

Die in den Figuren 4 bis 6 gezeigten Elemente (mit Ausnahme der Spannungsquelle 40 in Figur 6) können auf demselben GaAs-Substrat integriert werden. Ein Beispiel für eine solche Integration zeigt Figur 7, wo die fotolumineszierende Schicht 16 in einer pnp-Struktur plaziert ist, die aus 2 Transistoren besteht, welche differentialgeschaltet werden können. Die Schichten nach Figur 7 bestehen aus:

| | |
|---|---|
| Schicht 19, 20: | Metallschicht zur Bildung ohmscher Kontakte |
| Schicht 12: | p-dotiertes GaAs-Substrat |
| Schicht 16b: | p-dotiertes $Ga_{x_5}Al_{1-x_5}As$ |
| Schicht 41: | n-dotiertes $Ga_{x_6}Al_{1-x_6}As$ |
| Schicht 16: | p-dotiertes GaAs |
| Schicht 17: | p-dotiertes $Ga_{x_7}Al_{1-x_7}As$ |
| Schicht 42-45: | Metallschichten zur Bildung ohmscher Kontakte |
| Schicht 34 und 35: | Interferenzfilterschichten |

Das elektronische Äquivalent zeigt Figur 8, wobei die Anschlüsse 22, 23, 46, 47, 48 und 49 den markierten Anschlüssen in Figur 7 entsprechen.

Zur guten Funktion des Bausteins erhält die Schicht 16 eine hohe Lumineszenzeffektivität (lange Lebensdauer der erzeugten Ladungsträger), und die Schicht 15 erhält eine niedrige Lumineszenzeffektivität durch hohe Konzentration nicht-strahlender Rekombinationszentren.

Von den Basisströmen zum Transistor wird somit die Konzentration optisch erzeugter Ladungsträger in der Schicht 16 und damit die Fotolumineszenz von dieser Schicht gesteuert.

Durch Einfügung der Bausteine nach Figur 8 in elektronische Schaltungen wohlbekannter Art können genaue faseroptische Strom- und Spannungsmessungen vorgenommen werden.

Um einen größeren Meßsignalbereich zu erhalten, kann eine dünne Schicht mit hohem Al-Gehalt zwischen die Schichten 15 und 16 in Figur 2a und die Schichten 41 und 16 in Figur 7 gelegt werden. Dadurch werden erzeugte Ladungsträger weniger leicht von dem Feld am pn-Übergang aus der Schicht 16 abgesaugt, wodurch man eine gute Lumineszenzmodulation auch bei niedrigen Widerstandswerten der Elemente 36, 37, 38, 39 in den Figuren 4 und 5 und bei niedrigen Spannungen $U_x$ der Spannungsquelle 40 in Figur 6 erhält.

Die vorstehend beschriebene Erfindung kann im Rahmen des offenbarten, allgemeinen Erfindungsgedankens in vielfacher Weise variiert werden.

Patentanwalt und Rechtsanwalt
Dr.-Ing. Dipl.-Ing. Joachim B o e c k e r

6 Frankfurt/Main 1, 4.2.1983
Rathenauplatz 2 - 8
Telefon: (06 11) * 28 23 55
Telex: 4 189 066 itax d

**0088972**

21 239 PE

## PATENTANSPRÜCHE:

1. Faseroptische Meßanordnung zur Messung von vorzugsweise elektrischen und magnetischen Größen, wie z.B. Spannung, Strom, elektrische Feldstärke oder magnetisches Feld, das aus einem Geber (G) und einem Elektronik- und Optoelektronikteil (E) besteht, die über mindestens eine optische Faser (11) miteinander verbunden sind, wobei der Elektronik- und Optoelektronikteil (E) Lichtquellen (1, 2) zur optischen Erzeugung von Ladungsträgern in mindestens einer Materialschicht (16) des Gebers (G) enthält und mindestens einen Fotodetektor (63) zum Erfassen von vom Geber (G) ausgesandten Lumineszenzlicht (26) enthält, dadurch gekennzeichnet, daß der Geber (G) mindestens ein optisches Absorptionsfilter (13) oder Interferenzfilter (34, 35) enthält, daß der Elektronik- und Optoelektronikteil (E)mindestens zwei Lichtquellen (1, 2) mit verschiedenen Emissionsspektren (24, 25) enthält, daß die optischen Filter (13, 34, 35) im Strahlengang zwischen der Endfläche der optischen Faser (11) im Geber und der Materialschicht (16) derart angeordnet sind, daß die Filter (13, 34, 35) optisch genau definierte Flächen der Schicht (16) abdecken, daß jedes Filter (13, 34, 35) Lumineszenzlicht von der Schicht (16) und Anregungslicht von mindestens einer der Lichtquellen (1, 2) hindurchläßt und Anregungslicht von mindestens einer anderen der Lichtquellen (1, 2) blockiert, daß die in der Materialschicht (16) erzeugten Ladungsträger während des Aussendens von Licht rekombinieren, daß die Minoritätsladungsträgerkonzentration in der Materialschicht (16) von mindestens einem pn- oder Schottky-Übergang (15, 16) in der Nähe der Materialschicht (16) beeinflußt wird, und daß der Fotostrom durch und/oder die Spannung an diesem pn-Übergang von resistiven Sensorelementen (36, 37) und/oder Spannungsquellen (40) und/oder aktiven Halbleiterkomponenten, wie Dioden, bipolaren Transistoren (53, 54), Thyristoren,

/ 10

- 10 -

Tunneldioden und/oder Feldeffekttransistoren (38, 39) moduliert werden/wird.

2. Faseroptische Meßanordnung nach Anspruch 1, dadurch gekennzeichnet, daß die Materialschicht (16) auf beiden Seiten an Schichten (15, 17) mit größerem Bandabstand als die lumineszierende Schicht (16) grenzt und daß erzeugte Ladungsträger zumindest in einem Teil der Schicht (16) sich in einem Abstand von ca. einer Diffusionslänge von dem durch den genannten pn- oder Schottky-Übergang verursachten Verarmungsbereich befinden.

3. Faseroptische Meßanordnung nach Anspruch 2, dadurch gekennzeichnet, daß eine der angrenzenden Schichten (15) zusammen mit der lumineszierenden Materialschicht (16) einen pn-Übergang bildet.

4. Faseroptische Meßanordnung nach Anspruch 3, dadurch gekennzeichnet, daß eine dünne Schicht mit größerem Bandabstand (hoher Al-Gehalt in einem GaAlAs-System) in dem genannten pn-Übergang zwischen den angrenzenden Schichten (15, 16) vorhanden ist, die eine wohldefinierte Diffusionsbarriere für erzeugte Ladungsträger in der Schicht (16) bildet.

5. Faseroptische Meßanordnung nach Anspruch 3, dadurch gekennzeichnet, daß der genannte pn-Übergang zu einer npn- oder pnp-Struktur gehört, wobei die Basisschicht (41) in dem hierdurch gebildeten bipolaren Transistor den Ladungsträgertransport zwischen der lumineszierenden Schicht (16) und einer nichtlumineszierenden Schicht (16b) steuert, zwischen welchen sich die Basisschicht (41) befindet.

6. Faseroptische Meßanordnung nach einem der vorhergehenden Ansprüche, dadurch gekennzeichnet, daß von den Filtern (13, 34, 35) für das Anregungslicht (24, 25) optisch separierte Bereiche (13, 15 in Fig. 2b) der lumineszierenden Schicht (16) so ausgebildet und im Verhältnis zu den übrigen
Schichten im Geber angeordnet sind, daß elektrisch gesehen
ein Bauteil (32, 33, 53, 54) für jeden der genannten optisch
separierten Bereiche (13, 15) entsteht.

7. Faseroptische Meßanordnung nach Anspruch 6, dadurch gekennzeichnet, daß die genannten Bauteile (32, 33 usw.) dadurch gebildet werden, daß die optisch separierten Bereiche
(13, 15) elektrisch an äußere Schaltkreise über wenigstens
auf der einen Seite der Struktur (12, 13, 14, 15, 16, 17)
vorhandene getrennte Elektroden (19, 20) angeschlossen werden.

8. Faseroptische Meßanordnung nach Anspruch 7, dadurch gekennzeichnet, daß die genannten Bauteile durch Wegätzung(50)
von gemeinsamen elektrisch leitenden Schichten und/oder durch
Einführung sogenannter guard-Ringe elektrisch derart voneinander unabhängig gemacht sind, daß blockierende pn-Übergänge in seitlicher Richtung in den Schichten entstehen.

9. Faseroptische Meßanordnung nach Anspruch 7, dadurch gekennzeichnet, daß die genannten Bauteile mindestens zwei
parameterangepaßte Dioden (32, 33) oder Transistoren (53,
54) sind, wobei die Anpassung dadurch geschieht, daß die
zu den Bauteilen gehörenden Schichten (13, 14, 15, 16, 17,
16b, 41) gleichzeitig unter guter zeitlicher Prozeßkontrolle gewachsen sind.

10. Faseroptische Meßanordnung nach Anspruch 6, dadurch gekennzeichnet, daß die genannten Bauteile elektrisch an die
rsistiven Sensorelemente (36, 37), die Spannungsquellen
(40) und/oder die aktiven Halbleiterkomponenten (53, 54,
38, 39) derart angeschlossen werden, daß das von der Materialschicht (16) abgegebene Lumineszenzlicht (26)
Informationen sowohl über das Meßsignal ($V_x$) wie über ein
Bezugssignal ($V_{ref}$) enthält.

11. Faseroptische Meßanordnung nach Anspruch 10, dadurch gekennzeichnet, daß wenigstens eines der Bauteile (33) an ein Bezugselement (37, 39) und wenigstens ein anderes der genannten Bauteile an ein von der Meßgröße moduliertes Element (36, 38, 40) angeschlossen sind.

12. Faseroptische Meßanordnung nach Anspruch 10, dadurch gekennzeichnet, daß die Lichtquellen (1, 2) zeit- oder frequenzmultiplexiert sind, daß das von dem Anregungslicht der Lichtquellen (1, 2) verursachte Fotolumineszenzlicht (26) in den Bauteilen (36, 37) mit dafür geeigneten Detektorkreisen (6b, 65, 66) in dem Elektronik- und Optoelektronikteil (E) zeit- bzw. frequenzmultiplexiert wird, daß die dem demultiplexierten Fotolumineszenzlicht entsprechenden elektrischen Signale Berechnungsgliedern zugeführt werden, die als Ausgangsgröße ein Meßsignal liefern, welches von der Dämpfung in dem optischen Fasersystem, der Temperatur und der Alterung der zu dem Geber gehörenden Elemente (60, 36, 37, 38, 39 usw.) unabhängig ist, und/oder daß eins der dem demultiplexierten Fotolumineszenzlicht entsprechenden elektrischen Signale einem Regler zur Steuerung der Lichtstärkenrelation zwischen den Lichtquellen (1, 2) zugeführt wird.

13. Faseroptische Meßanordnung nach Anspruch 12, dadurch gekennzeichnet, daß das genannte Brechnungsglied eine oder mehrere Quotientenbildungen und eventuell eine oder mehrere Subtraktionen, Summierungen und/oder Multiplikationen durchführt.

FIG. 1

FIG. 2a

22  19  12  13  14  15  16  17

18

11

23

20

21

FIG. 2b

11

12

15

13

FIG. 3a

FIG. 3b

FIG. 4

FIG. 5

FIG. 6

FIG. 7

FIG. 8

Europäisches
Patentamt

EUROPÄISCHER RECHERCHENBERICHT

0088972
Nummer der Anmeldung

EP 83 10 2190

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | EP-A-0 010 221 (ASEA-AB) * Seite 1, Zeile 20 - Seite 6, Zeile 15; Abbildungen 1,2 * | 1 | G 01 R 15/07 H 01 L 31/12 G 01 D 5/26 |
| | --- | | |
| A | GB-A-1 540 907 (STANDARD TELEPHONES AND CABLES LTD.) * Seite 1, linke Spalte, Zeilen 15-28; Seite 2, rechte Spalte, Zeilen 86-102, 117-130; Seite 3, linke Spalte, Zeilen 41-59; Abbildungen 5,8 * | 1 | |
| | --- | | |
| A,P | DE-A-3 136 448 (ASEA-AB) | | |
| | --- | | |
| A,P | DE-A-3 217 078 (ASEA-AB) | | |
| | ----- | | |

RECHERCHIERTE SACHGEBIETE (Int. Cl. ³)

G 01 R
H 01 L
H 04 B
G 01 D

Der vorliegende Recherchenbericht wurde für alle Patentansprüche erstellt.

| Recherchenort DEN HAAG | Abschlußdatum der Recherche 29-06-1983 | Prüfer KUSCHBERT D.E. |
|---|---|---|